# FASCICULE DE BREVET EUROPEEN

(11) **EP 0 680 248 B1**
(45) Date de publication et mention de la délivrance du brevet: **10.03.1999**
(21) Numéro de dépôt: 95400744.9
(22) Date de dépôt: 03.04.1995
(51) Int. Cl.: H05K 3/32, H01R 9/09

(54) **Procédé de fabrication d'un circuit électronique de puissance et circuit électronique obtenu par ce procédé**
Verfahren zur Herstellung einer elektronischen Leistungsschaltung und nach diesem Verfahren erhaltene elektronische Schaltung
Process for manufacturing a power electric circuit and electronic circuit obtained by this process

(30) Priorité: 25.04.1994 FR 9404966
(43) Date de publication de la demande: 02.11.1995
(73) Titulaire: AUTOMOBILES PEUGEOT, 75116 Paris (FR); AUTOMOBILES CITROEN, 92200 Neuilly-sur-Seine (FR)
(72) Inventeur: Coustre, André, F-78570 Chanteloup Les Vignes (FR); Auffret, Rémi, F-91440 Bures Sur Yvette (FR); Durand, Claude, F-92260 Fontenay Aux Roses (FR)
(74) Mandataire: Polus, Camille

(56) Documents cités:
- EP-A- 0 159 208
- DE-U- 9 203 941
- DE-U- 9 217 684
- DE-U- 9 312 961
- GB-A- 2 221 357
- US-A- 5 065 283
- US-A- 5 263 247
- PATENT ABSTRACTS OF JAPAN vol. 17, no. 193 (E-1351) 15 Avril 1993 & JP-A-04 341 773 (MITSUBISHI ELECTRIC CORP) 27 Novembre 1992

## Description

La présente invention concerne un procédé de fabrication d'un circuit électronique de puissance, ainsi qu'un circuit électronique obtenu par ce procédé.

Il est important, lors de la fabrication d'un circuit électronique de puissance, de prévoir une bonne dissipation de la chaleur dégagée par les différents composants qui le constituent, notamment par des circuits intégrés de puissance, afin d'éviter leur surchauffe, et de prévoir une bonne protection contre l'humidité.

En effet, l'humidité s'infiltre dans les composants et amène progressivement leur destruction. En outre, une augmentation de la température des composants de 10°C réduit leur durée de vie de moitié.

On connaît des procédés de fabrication de circuits électroniques de puissance permettant de pallier ces inconvénients. En effet, le document EP-A-0 159 208 décrit un tel procédé de fabrication dans lequel des composants électroniques sont posés à plat puis brasés sur un réseau conducteur formant circuit imprimé préalablement obtenu à partir d'une plaque de métal, généralement en cuivre, disposée sur un matériau bon conducteur de la chaleur, par exemple de l'aluminium, et entre lesquels est insérée une couche de matériau isolant de l'électricité.

Cette structure permet d'obtenir une faible résistance thermique entre le coeur des composants électroniques par exemple de puissance et le matériau bon conducteur de la chaleur. Les calories dégagées par ces composants de puissance peuvent ainsi être transmises à la couche conductrice de la chaleur, et être évacuées par une source froide.

Cependant, l'épaisseur de cuivre du réseau conducteur se situant généralement dans une plage allant de 35 microns à 105 microns, les circuits imprimés ne peuvent pas conduire efficacement des flux de courant importants nécessaires à l'alimentation de circuits intégrés de forte puissance.

On a tenté de pallier cet inconvénient en proposant un procédé de fabrication d'un circuit électronique de puissance dans lequel on soude au circuit imprimé des barres de courant permettant de véhiculer un tel flux de courant.

Cependant, ce procédé présente plusieurs inconvénients.

En effet lors de la fabrication de circuits électroniques les différents composants sont généralement soudés simultanément au circuit imprimé par brasage. Cette opération est classiquement réalisée dans un four par exemple à infrarouge. Cependant, la hauteur de ces barres de courant ne permet pas d'insérer la plaque de circuit imprimé munie de ces barres dans le four, et de plus leurs dimensions importantes forment un écran empêchant la bonne brasure des autres composants.

Les barres doivent par conséquent être brasées manuellement après le montage des composants. Ce brasage manuel est cher et mal maîtrisé et nécessite l'utilisation d'une plaque chauffante, ce qui risque de provoquer une dégradation des brasures des composants préalablement réalisées dans le four.

De plus, le remplacement d'un circuit intégré défaillant postérieurement au brasage de ces barres de courant est une opération très délicate car il est alors nécessaire de dessouder une ou plusieurs barres pour permettre l'accès à ce circuit défaillant, ce qui peut entraîner une dégradation des autres brasures.

Un but de la présente invention est de proposer un procédé de fabrication d'un circuit électronique de puissance permettant de pallier ces inconvénients.

Un autre but de l'invention est de proposer un procédé de fabrication d'un circuit électronique de puissance, facilement automatisable et permettant le montage de composants dont les dimensions sont incompatibles avec des machines de montage de composants, et ne pouvant pas subir d'opération de brasage.

A cet effet, la présente invention a pour objet un procédé de fabrication d'un circuit électronique de puissance comprenant des composants reliés par brasage à des emplacements de connexion d'un réseau conducteur d'une plaque de circuit imprimé, dans lequel on forme le réseau conducteur du circuit imprimé en fonction du circuit à réaliser, on dépose de la pâte à braser sur les emplacements de connexion du réseau, on place sur la plaque des premiers composants destinés à être fixés par brasage sur des emplacements de connexion du réseau de celle-ci, on place, sur une partie des emplacements de connexion du réseau de la plaque, des plots de raccordement en matériau conducteur destinés à recevoir des seconds composants à mettre en place sur la plaque après l'opération de brasage, on procède à l'opération de brasage des premiers composants et des plots de raccordement, et on fixe les seconds composants sur les plots de raccordement à l'aide de moyens de fixation mécaniques, caractérisé en ce que les premiers composants comportent des circuits intégrés de puissance et les seconds composants comportent des barres de courant reliées à la plaque par les plots de raccordement.

L'invention a également pour objet un circuit électronique de puissance réalisé au moyen du procédé de fabrication tel que défini ci-dessus.

D'autres caractéristiques et avantages de l'invention ressortiront de la description suivante, donnée à titre d'exemple et sans caractère limitatif, en regard des dessins annexés dans lesquels :
- la figure 1 représente un circuit électronique de puissance obtenu au moyen d'un procédé de fabrication selon l'art antérieur;
- la figure 2 représente une vue schématique de profil d'un circuit électronique obtenu à l'aide d'un procédé de fabrication selon l'invention ;
- la figure 3 représente une vue schématique de dessus d'un circuit électronique de puissance en cours de réalisation, suivant le procédé de fabrication selon l'invention ;
- la figure 4 représente une vue schématique en perspective d'un plot de raccordement utilisé dans le procédé de fabrication selon l'invention ;
- la figure 5 représente une vue schématique en coupe d'un détail d'un autre mode de réalisation d'un circuit électronique au moyen du procédé selon l'invention.

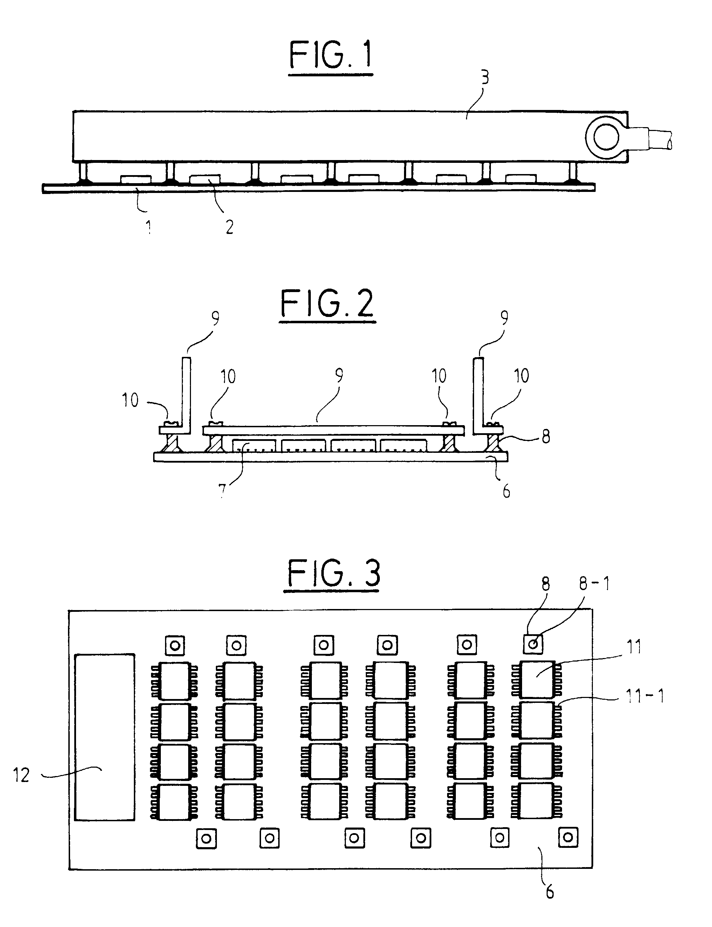

La figure 1 représente un circuit électronique selon l'art antérieur muni d'éléments de connexion permettant de faire circuler un courant important dans certaines parties de la plaque. Ce circuit se compose d'une plaque 1 de circuit imprimé sur lequel sont soudés des composants ou circuits intégrés de puissance 2 et un ensemble de barres de courant 3 dont une seule est représentée sur cette figure. Cette barre est adaptée pour assurer une liaison électrique de forte puissance entre les circuits 2 et des dispositifs externes (non représentés).

Chaque barre de courant est bridée mécaniquement sur la plaque, à chacune de ses extrémités, à l'aide de vis et de canons isolants.

Ainsi qu'on l'a mentionné précédemment cette structure présente certains inconvénients notamment au niveau de son coût et du remplacement des composants défaillants qui nécessite le démontage d'une ou de plusieurs barres.

Pour pallier ces inconvénients et suivant le procédé selon l'invention, on fixe par brasage sur des emplacements de connexion d'une plaque de circuit imprimé des plots de raccordement sur lesquels différents composants sont ensuite fixés.

Le terme composant désigne ici tout élément entrant dans la constitution d'un circuit électronique, notamment des circuits intégrés, des éléments formant liaison électrique ou mécanique, etc...

On a représenté sur la figure 2 un exemple de réalisation d'un circuit électronique muni de tels plots.

Ce circuit se compose d'une plaque de circuit imprimé 6 sur laquelle ont été brasés des circuits intégrés 7 et des plots de raccordement 8. Des barres de courant 9 sont fixées aux plots par des moyens mécaniques 10 tels que des vis. Ces barres sont de préférence de dimensions suffisantes pour permettre de faire circuler dans la plaque des flux de courant importants, par exemple de l'ordre de 300 A.

La plaque de circuit imprimé 6 recevant les composants, est formée de façon connue par exemple d'une couche de matériau conducteur, par exemple du cuivre, déposée sur une couche de matériau bon conducteur de la chaleur, par exemple de l'aluminium, avec interposition d'une couche de matériau isolant comme un film plastique, entre ces couches.

Le procédé de fabrication de ce circuit électronique va maintenant être décrit en référence aux figures 3 à 5.

Sur ces figures, des éléments identiques à ceux illustrés sur la figure 2 portent les mêmes numéros de référence.

A partir d'une plaque composée de couches de matériaux conducteur, isolant et bon conducteur de la chaleur, on procède à la formation du réseau conducteur du circuit imprimé, en fonction du circuit à réaliser, en enlevant les parties non nécessaires à la couche de matériau conducteur, de façon connue en soi.

On dépose ensuite de la pâte à braser sur des emplacements de connexion de ce réseau conducteur pour relier ultérieurement lors d'une opération de brasage les composants à la plaque.

On procède ensuite au dépôt sur la plaque dont les emplacements de connexion sont enduits de pâte à braser, de premiers composants 11 (analogues aux composants 7 décrits précédemment) et par exemple d'un boîtier de commande 12, destinés à être fixés par brasage sur celle-ci.

Ces premiers composants 11 sont par exemple des circuits intégrés de puissance placés sur le réseau conducteur de telle sorte que leurs bornes de raccordement 11-1 soient en contact avec de la pâte à braser sur des emplacements de connexion de ce réseau, et que leurs boîtiers soient en contact direct avec la couche de matériau conducteur de façon à dissiper l'énergie calorifique qu'ils dégagent lorsqu'ils sont en fonctionnement.

La mise en place de ces premiers composants sur la plaque peut de façon connue être réalisée par des machines automatiques.

Simultanément au dépôt de ces premiers composants on procède à la mise en place sur une partie des emplacements de connexion du réseau, enduits de pâte à braser, des plots de raccordement 8.

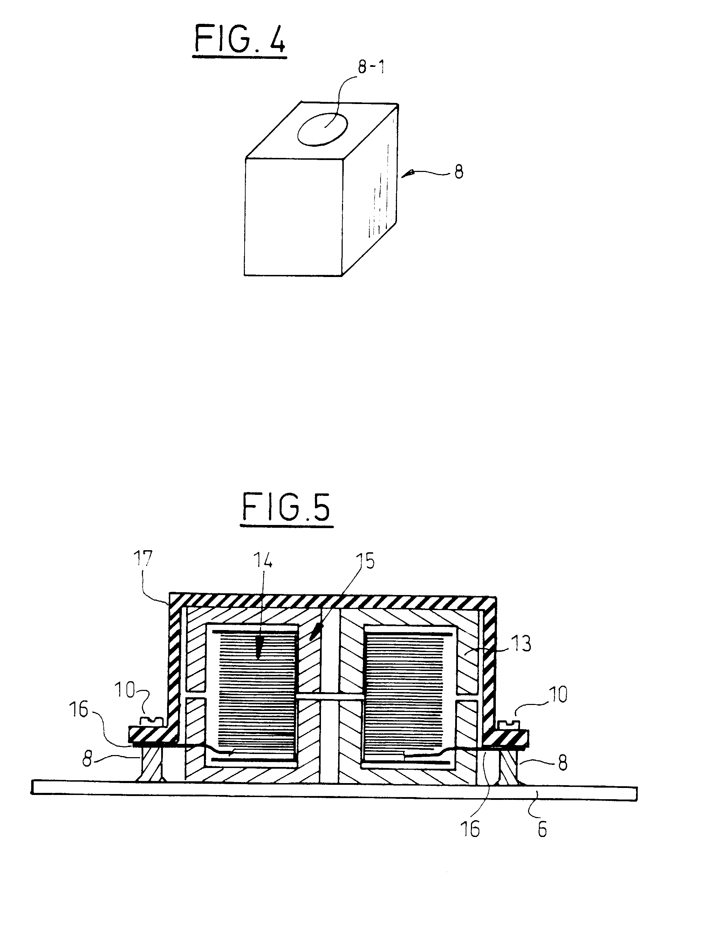

On a représenté sur la figure 4 un exemple de réalisation d'un tel plot de raccordement 8. Il s'agit d'un élément en matériau conducteur, par exemple du laiton ou du cuivre, de préférence de forme parallélépipédique, de 3 à 6 mm de côtés.

Selon un mode de réalisation préféré de ce plot, il forme une base carrée de 5 mm de côté sur laquelle il repose, et une hauteur de 6 mm. Il est percé d'un orifice 8-1 axial. Cet orifice peut avantageusement être taraudé ou auto-taraudable et être adapté pour recevoir par exemple une vis. Ce plot est en outre recouvert d'une couche de matériau d'étamage de 5 microns d'épaisseur afin de favoriser la brasure.

Ces plots 8 peuvent être placés sur la plaque de circuit imprimé d'une façon identique à celle utilisée pour les premiers composants, c'est-à-dire au moyen d'une machine à déposer des composants automatique.

Une fois ces différents éléments en place sur la plaque, on procède au brasage des connexions de manière à relier de façon électrique et mécanique les composants, c'est-à-dire les circuits intégrés 11 et les plots 8, qui ont été préalablement placés sur les emplacements de connexion de la plaque recouverts de brasure, au réseau conducteur et à la plaque.

Après avoir réalisé cette opération de brasage, on fixe par des moyens mécaniques des seconds composants sur les plots de raccordement 8. On relie ainsi à la plaque durant cette étape, tous les composants qui ne peuvent pas subir de brasage du fait de leur taille incompatible avec celle du four, de leur structure ne leur permettant pas de supporter la température de passage au four, ou qui formeraient un écran empêchant la bonne brasure des autres composants.

On peut ainsi fixer sur ces plots de raccordement 8 des barres de courant 9 de dimensions suffisantes pour permettre de faire circuler dans la plaque des flux de courant importants.

Ces barres de courant sont munies, par exemple à proximité de leurs extrémités, de trous de passage par exemple d'une vis 10 qui pénètre dans l'orifice 8-1 du plot de raccordement 8 correspondant, de façon à réaliser une liaison mécanique et électrique de cette barre sur la plaque par l'intermédiaire de ce plot.

On obtient alors un circuit comprenant un premier réseau conducteur formé sur la plaque de matériau conducteur pour faire circuler un flux de courant faible et un second réseau conducteur s'étendant au dessus du premier, pour la circulation de forts courants, tel que représenté sur la figure 2.

On peut également si on le désire fixer ainsi à la plaque des éléments de taille importante ne pouvant pas subir d'opération de brasage, du fait de leur structure ou de leur taille.

On a représenté sur la figure 5 un circuit électronique sur lequel un composant électrique tel qu'un transformateur 13 a été fixé à la plaque de circuit imprimé postérieurement au brasage en mettant en oeuvre le procédé selon l'invention.

Ce transformateur 13 se compose d'un bobinage 14 enfermé dans un corps de ferrite 15. Les caractéristiques magnétiques de la ferrite se dégradant en général à la chaleur de manière irréversible, ce transformateur ne peut être fixé sur la plaque par brasage au four.

Après avoir effectué les soudures des connexions, ce transformateur est alors placé manuellement sur la plaque après le passage de celle-ci au four pour le brasage des composants et des plots de telle sorte que sa carcasse soit en contact avec la couche de matériau conducteur de celle-ci. On relie par la suite des éléments conducteurs 16, par exemple des cosses de raccordement des bornes d'alimentation de ce transformateur, aux plots 8 de raccordement de façon à réaliser une liaison électrique entre ce transformateur et le circuit imprimé.

On fixe ensuite mécaniquement le transformateur à la plaque au moyen d'une bride isolante 17 qui l'entoure et qui est reliée par vissage aux plots de raccordement 8.

Ce transformateur est alors maintenu en contact thermique, mécanique et électrique avec le circuit imprimé.

Après avoir placé sur la plaque les premiers et les seconds composants, on procède enfin à l'encapsulage du circuit dans un boîtier étanche afin de protéger ces composants contre l'humidité.

Ce procédé de réalisation d'un circuit imprimé de puissance permet par conséquent de réaliser à l'aide d'automates des circuits imprimés sur lesquels un grand nombre de types de composants peuvent être placés, tout en permettant leur remplacement de façon aisée.

## Revendications

1. Procédé de fabrication d'un circuit électronique de puissance comprenant des composants reliés par brasage à des emplacements de connexion d'un réseau conducteur d'une plaque de circuit imprimé (6), dans lequel on forme le réseau conducteur du circuit imprimé en fonction du circuit à réaliser, on dépose de la pâte à braser sur les emplacements de connexion du réseau, on place sur la plaque des premiers composants (7,11) destinés à être fixés par brasage sur des emplacements de connexion du réseau de celle-ci, on place, sur une partie des emplacements de connexion du réseau de la plaque, des plots de raccordement (8) en matériau conducteur destinés à recevoir des seconds composants (9;13) à mettre en place sur la plaque après l'opération de brasage, on procède à l'opération de brasage des premiers composants (7,11) et des plots de raccordement (8), et on fixe les seconds composants (9;13) sur les plots de raccordement à l'aide de moyens de fixation mécaniques (10), caractérisé en ce que les premiers composants comportent des circuits intégrés de puissance (7,11) et les seconds composants comportent des barres de courant (9) reliées à la plaque par les plots de raccordement.

2. Procédé selon la revendication 1, caractérisé en ce que les seconds composants comportent en outre des composants électriques (13) positionnés entre des plots de raccordement (8), et munis de brides isolantes (17) fixées mécaniquement aux plots et adaptées pour relier mécaniquement ces composants à la plaque et d'éléments conducteurs (16) assurant une liaison électrique entre les plots de raccordement et ces composants électriques.

3. Procédé selon l'une des revendications 1 et 2, caractérisé en ce que les plots de raccordement (8) se présentent sous la forme d'un parallélépipède, muni d'un orifice axial (8-1) de réception des moyens de fixation des seconds composants.

4. Procédé selon l'une quelconque des revendications 1 à 3, caractérisé en ce que les plots de raccordement sont recouverts d'une couche d'étamage.

5. Procédé selon l'une quelconque des revendications 1 à 4, dans lequel on procède à l'encapsulage du circuit imprimé dans un boîtier étanche, postérieurement à la fixation des seconds composants sur la plaque.

6. Circuit électronique de puissance réalisé au moyen du procédé de fabrication selon l'une quelconque des revendications 1 à 5, comportant une plaque de circuit imprimé (6) sur des emplacements de connexion de laquelle sont brasés des premiers composants et des plots de raccordement (8), lesdits plots de raccordement (8) reliant des seconds composants aux emplacements de connexion correspondants, caractérisé en ce que les seconds composants comprennent des barres de courant (9).

7. Circuit électronique de puissance selon la revendication 6, caractérisé en ce que les seconds composants comprennent en outre au moins un composant électrique (13).

## Patentansprüche

1. Verfahren zur Herstellung einer elektronischen Leistungsschaltung, die Komponenten aufweist, die durch Löten mit Verbindungsstellen eines leitenden Netzes einer gedruckten Schaltungsplatte (6) verbunden sind, bei dem das leitende Netz der gedruckten Schaltung in Abhängigkeit von der herzustellenden Schaltung gebildet wird, Lötpaste auf die Verbindungsstellen des Netzes aufgebracht wird, auf der Platte erste Komponenten (7, 11) angeordnet werden, die dazu bestimmt sind, durch Löten an Verbindungsstellen des Netzes derselben befestigt zu werden, auf einem Teil der Verbindungsstellen des Netzes der Platte Anschlußelemente (8) aus einem leitenden Material angebracht werden, die dazu bestimmt sind, zweite Komponenten (9; 13) aufzunehmen, die auf der Platte nach dem Lötverfahren angeordnet werden sollen, das Anlöten der ersten Komponenten (7, 11) und der Anschlußelemente (8) vorgenommen wird und die zweiten Komponenten (9; 13) an den Anschlußelementen mit Hilfe von mechanischen Befestigungsmitteln (10) befestigt werden, dadurch gekennzeichnet, daß die ersten Komponenten integrierte Leistungsschaltungen (7, 11) umfassen und die zweiten Komponenten Stromstäbe (9) umfassen, die mit der Platte durch die Anschlußelemente verbunden sind.

2. Verfahren nach Anspruch 1, dadurch gekennzeichnet, daß die zweiten Komponenten ferner elektrische Komponenten (13) umfassen, die zwischen Anschlußelementen (8) angeordnet sind und die versehen sind mit Isolierflanschen (17), die mechanisch an den Elementen befestigt und derart ausgeführt sind, daß sie mechanisch diese Komponenten mit der Platte verbinden, sowie mit leitenden Elementen (16), die eine elektrische Verbindung zwischen den Anschlußelementen und diesen elektrischen Komponenten gewährleisten.

3. Verfahren nach einem der Ansprüche 1 und 2, dadurch gekennzeichnet, daß die Anschlußelemente (8) die Form eines Parallelepipeds aufweisen, das mit einer Axialöffnung (8-1) für die Aufnahme der Befestigungsmittel der zweiten Komponenten versehen ist.

4. Verfahren nach einem der Ansprüche 1 bis 3, dadurch gekennzeichnet, daß die Anschlußelemente mit einer verzinnten Schicht überzogen sind.

5. Verfahren nach einem der Ansprüche 1 bis 4, bei dem eine Einkapselung der gedruckten Schaltung in einem dichten Kasten nach der Befestigung der zweiten Komponenten auf der Platte vorgenommen wird.

6. Elektronische Leistungsschaltung, die mit Hilfe des Herstellungsverfahrens nach einem der Ansprüche 1 bis 5 hergestellt wurde, die eine gedruckte Schaltungsplatte (6) umfaßt, an deren Verbindungsstellen erste Komponenten und Anschlußelemente (8) angelötet sind, wobei die Anschlußelemente (8) zweite Komponenten mit den entsprechenden Verbindungsstellen verbinden, dadurch gekennzeichnet, daß die zweiten Komponenten Stromstäbe (9) umfassen.

7. Elektronische Leistungsschaltung nach Anspruch 6, dadurch gekennzeichnet, daß die zweiten Komponenten ferner mindestens eine elektrische Komponente (13) umfassen.

## Claims

1. Process for the production of an electronic power circuit comprising components connected by brazing to the connection locations of a conductor network of a printed circuit board (6), in which the conductor network of the printed circuit is formed according to the circuit to be produced, brazing solder is deposited on the connection locations of the network, first components (7, 11) intended for fixture by brazing on the connection locations of the network of the board are placed thereon, contact studs (8) of conductive material intended to receive second components (9; 13) for placement on the board after the brazing operation are placed on a part of the connection locations of the network of the board, the brazing operation of the first components (7, 11) and the contact studs (8) is performed, and the second components (9; 13) are fixed on the contact studs by means of mechanical fixing means (10), characterised in that the first components comprise integrated power circuits (7, 11) and the second components comprise busbars (9) connected to the board by the contact studs.

2. Process according to Claim 1, characterised in that the second components additionally comprise electrical components (13) positioned between the contact studs (8) and provided with insulating clamps (17) fixed mechanically to the studs and adapted to mechanically connect these components to the board and provided with conductive elements (16) assuring an electrical connection between the contact studs and these electrical components.

3. Process according to one of Claims 1 and 2, characterised in that the contact studs (8) have a parallelepipedal shape, are provided with an axial orifice (8-1) for receiving the fixing means of the second components.

4. Process according to any one of Claims 1 to 3,
characterised in that the contact studs are covered with a tinning layer.

5. Process according to any one of Claims 1 to 4, in which the printed circuit is encapsulated in a sealed casing subsequently to fixture of the second components on the board.

6. Electronic power circuit formed by means of the process of production according to any one of Claims 1 to 5,
comprising a printed circuit board (6), on connection locations of which first components and contact studs (8) are brazed, said contact studs (8) connecting second components to the corresponding connection locations,
characterised in that the second components comprise busbars (9).

7. Electronic power circuit according to Claim 6,
characterised in that the second components additionally comprise at least one electrical component (13).
